# EUROPEAN PATENT APPLICATION

(11) **EP 1 775 771 A2**
(43) Date of publication of application: **18.04.2007**
(21) Application number: 06017720.1
(22) Date of filing: 25.08.2006
(51) Int. Cl.: H01L 27/146, H01L 21/762

(54) **Method for producing shallow trench isolations (STI) of semiconductor devices**

(30) Priority: 14.10.2005 JP 2005300631
(71) Applicant: Matsushita Electric Industrial Co., Ltd., Osaka 571-8501 (JP)
(72) Inventor: Ochi, Motoka c/o Intellectual Property Rights, Chuo-ku Osaka-shi Osaka 540-6319 (JP); Tsuno, Morikazu c/o Intellectual Property Rights, Chuo-ku Osaka-shi Osaka 540-6319 (JP)
(74) Representative: Stippl, Hubert

(57) **Abstract**

A method for forming STIs 7 in a semiconductor substrate 1 includes forming a protective oxide film on the semiconductor substrate and forming a silicon nitride film on the protective oxide film, performing a photolithography and a dry etching so as to penetrate the silicon nitride film and the protective oxide film and remove part of the semiconductor substrate, thus forming groove portions, forming a buried oxide film in the groove portions and on the silicon nitride film, removing the buried oxide film on the silicon nitride film and a surface portion of the silicon nitride film by a CMP, and removing part of the buried oxide film deposited in the groove portions by a wet etching. It is possible to provide a method for producing STIs capable of forming uniform STI step heights in a semiconductor device with a fine structure.

## Description

The present invention relates to a semiconductor device, in particular, a solid-state imaging device using an active pixel MOS sensor, and a method for producing the same.

For the element isolation in a semiconductor device, an STI (Shallow Trench Isolation) structure is used especially in the case of constituting an element using a fine pattern technology of 0.25 µm or finer.

Also, with increasingly finer cells in a solid-state imaging device using an active pixel MOS sensor in recent years, the fine pattern technology of 0.25 µm or finer, namely, the element isolation of the STI structure has come to be adopted. The following is a description of such a solid-state imaging device in which an active pixel MOS sensor is mounted.

The solid-state imaging device using an active pixel MOS sensor has a configuration in which a signal detected by a photodiode in each pixel is amplified by a transistor, and has a high sensitivity. In addition, this solid-state imaging device can be produced by adding a photodiode formation process to a CMOS logic process, and therefore has features of allowing the shortened developing times, low cost and low power consumption.

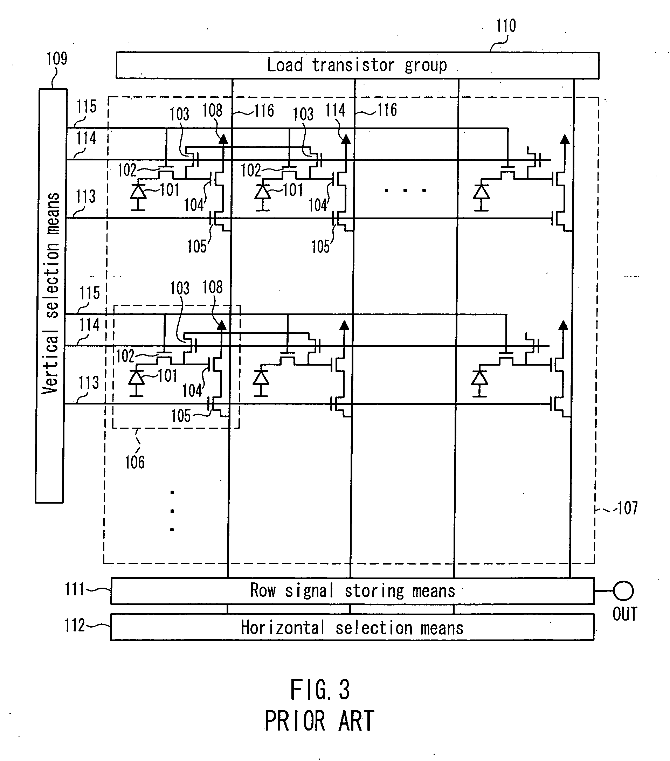

FIG. 3 shows a circuit configuration of a conventional MOS-type solid-state imaging device. This solid-state imaging device is constituted by a pixel region 107 and a peripheral circuit region disposed around the pixel region 107. In the pixel region 107, pixels 106 serving as unit cells are arranged two-dimensionally. Each of the pixels 106 includes a photodiode 101, a transfer transistor 102 for transferring a signal obtained by the photodiode 101, a reset transistor 103 for resetting a signal, an amplification transistor 104 for amplifying a signal, and a vertical selection transistor 105 for selecting a line from which a signal is to be read out. A connection portion 108 is connected to a pixel portion power supply. The peripheral circuit region includes a vertical selection means 109, a load transistor group 110, a row signal storing means 111 including a switch transistor, and a horizontal selection means 112.

A fine CMOS image sensor used for the MOS-type solid-state imaging device with the above-described configuration is disclosed by, for example, JP 2001-345439 A. FIG. 4 is a sectional view showing the MOS-type solid-state imaging device disclosed in JP 2001-345439 A. A major part of the MOS-type solid-state imaging device corresponds to the pixel region 107 in which the photodiodes 101 are disposed repeatedly.

In the pixel region 107, an n-type signal storing region 125 of the photodiode 101 is formed. A gate electrode 123a for transferring a stored electric charge to an n-type drain region 124a is formed on a silicon substrate via a gate insulating film (a silicon oxide film) 122. In a peripheral circuit region 117, a pMOS transistor is formed in an n-well 126, and an nMOS transistor is formed in a p-well 127. In the pixel region 107 and the peripheral circuit region 117, the elements are insulated by an STI 121.

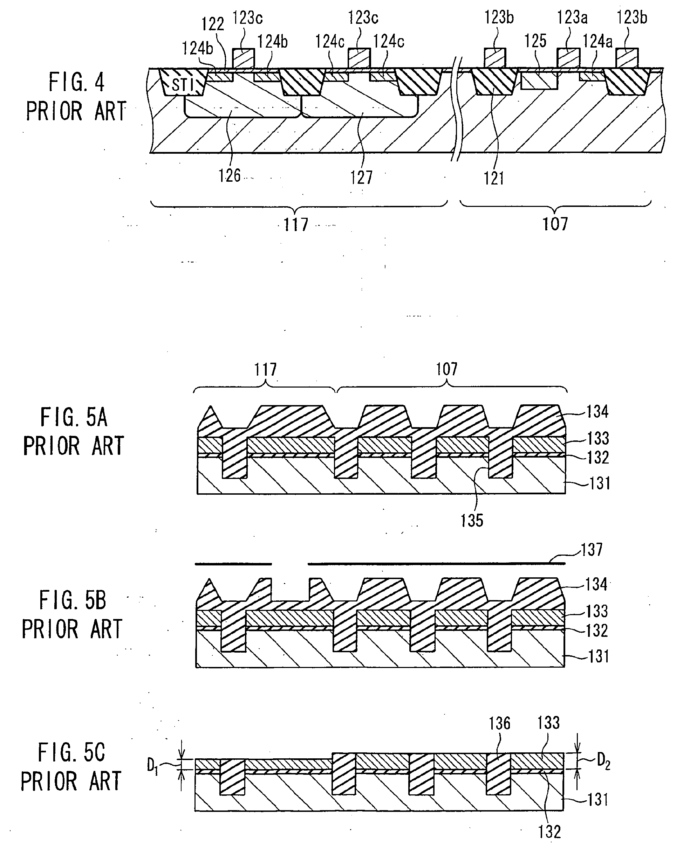

FIG. 5 is a sectional view showing a conventional process for producing STIs. FIG. 5 illustrates the pixel region 107 and the peripheral circuit region 117. First, as shown in FIG. 5A, a protective oxide film 132 and a silicon nitride film 133 are formed on a semiconductor substrate 131. Next, silicon trenches 135 that penetrate the protective oxide film 132 and the silicon nitride film 133 and provide grooves in the semiconductor substrate 131 are formed. Then, an NSG film 134 is deposited so as to fill the silicon trenches 135.

Subsequently, as shown in FIG. 5B, in a region where the element is formed between the STIs in the peripheral circuit region 117 (an active region), the NSG film 134 is ground by photolithography and dry etching using a reverse mask 137. This reduces a load of CMP in the subsequent process. Next, as shown in FIG. 5C, the NSG film 134 deposited on the silicon nitride film 133 is removed by CMP, thus forming STIs 136. Further, the silicon nitride film 133 and the protective oxide film 132 are removed, though not shown in the figure.

In FIG. 5B, it also is possible to grind the active region of the pixel region 107 using the reverse mask 137. However, because of the very fine dimensions of the active region of the pixel region 107 in the MOS-type solid-state imaging device, the NSG film 134 cannot be etched unless an extremely fine resist opening pattern is formed. Accordingly, after etching the NSG film 134 only in the peripheral circuit region 117, the CMP is carried out.

By the processes described above, the STIs can be formed. Furthermore, a semiconductor element is formed between the STIs by a general method, thus producing a semiconductor device.

However, in the conventional method for forming the STIs described above, the NSG film 134 is etched using the reverse mask only in the peripheral circuit region 117. Accordingly, the amount of the NSG film 134 to be polished by the CMP becomes relatively small in the peripheral circuit region 117. Thus, the NSG film 134 is polished faster, so that the silicon nitride film 133 and the STIs 136 partially are ground as shown in FIG. 5C. This increases the difference in STI step height (a difference between the levels of the STI and the surface of the semiconductor substrate) between the pixel region 107 and the peripheral circuit region 117 (|D1 - D2|). In particular, with increasingly finer cells accompanying finer element isolation, it becomes difficult to flatten the pixel region 107 by the CMP, resulting in a larger STI step height in the pixel region 107. Due to the stress caused by the larger STI step height (especially in the case where polysilicon is formed on the STIs), it is more likely that image defects occur in the solid-state imaging device.

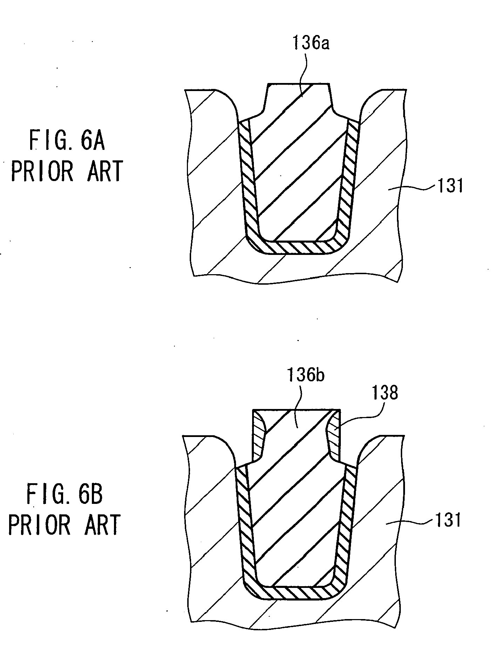

FIG. 6A shows a cross-section of the STI when the STI step height is small, and FIG. 6B shows a cross-section of the STI when the STI step height is large. When the STI step height is large, a PS (polysilicon) residue 138 is left on lateral walls of an STI 136b, thus bridging adjacent gates for the element isolation. This generates image defects (in particular, represented by black marks and white marks), which is one drawback of solid-state imaging devices.

It is an object of the present invention to provide a method for producing a semiconductor device capable of forming uniform STI step heights in a semiconductor device with a fine structure.

In order to achieve the above-mentioned object, a method for forming STIs according to the present invention is a method for forming STIs in a semiconductor substrate, including forming a protective oxide film on the semiconductor substrate and forming a silicon nitride film on the protective oxide film, performing a photolithography and a dry etching so as to penetrate the silicon nitride film and the protective oxide film and remove part of the semiconductor substrate, thus forming groove portions, forming a buried oxide film in the groove portions and on the silicon nitride film, removing the buried oxide film on the silicon nitride film and a surface portion of the silicon nitride film by a CMP, and removing part of the buried oxide film deposited in the groove portions by a wet etching.

Also, a method for producing a semiconductor device according to the present invention is characterized by forming a semiconductor element between the STIs formed by the above-described method for forming STIs.

Further, a semiconductor device according to the present invention is characterized in that, in a semiconductor device produced by the above-described production method, a height of an upper end of the STIs is equal to or smaller than 40 nm from the semiconductor substrate.

With the semiconductor device according to the above-described production method, it is possible to suppress a slight leakage electric current between adjacent gates. Also, various stresses applied to a semiconductor substrate can be relieved, thereby suppressing the generation of crystal defects. Accordingly, it is possible to suppress the generation of image defects sufficiently in the MOS-type solid-state imaging device using a semiconductor device with a fine structure and thus improve the performance thereof.
FIGs. 1A to 1F are sectional views showing processes in a method for producing a solid-state imaging device according to an embodiment of the present invention.
FIG. 2 is a graph showing remaining film thicknesses and variations of a silicon nitride film after a CMP process.
FIG. 3 is a schematic circuit diagram showing a configuration of a solid-state imaging device using an active pixel MOS sensor.
FIG. 4 is a sectional view showing a solid-state imaging device in a conventional example.
FIGs. 5A to 5C are sectional views showing processes in a conventional method for forming STIs.
FIG. 6A is a sectional view showing a case in which an STI step height is small.
FIG. 6B is a sectional view showing a case in which the STI step height is large.

In the method for forming STIs according to the present invention, a thickness of the surface portion of the silicon nitride film removed by the CMP may be equal to or smaller than 50% of a thickness of the silicon nitride film that is formed, and a thickness of the buried oxide film removed by the wet etching may be 10% to 50% of a thickness of the silicon nitride film before the CMP.

Also, in the method for producing a semiconductor device according to the invention of the present application, the semiconductor element may be formed so as to form a photodiode for converting incident light into an electrical charge and storing it, and a MOS transistor forming a readout portion for reading out a signal charge from the photodiode, a driving portion or an amplification portion for amplifying an output signal.

The following is a specific description of an embodiment of a semiconductor device in the present invention, in particular, a solid-state imaging device as an example, with reference to the accompanying drawings.

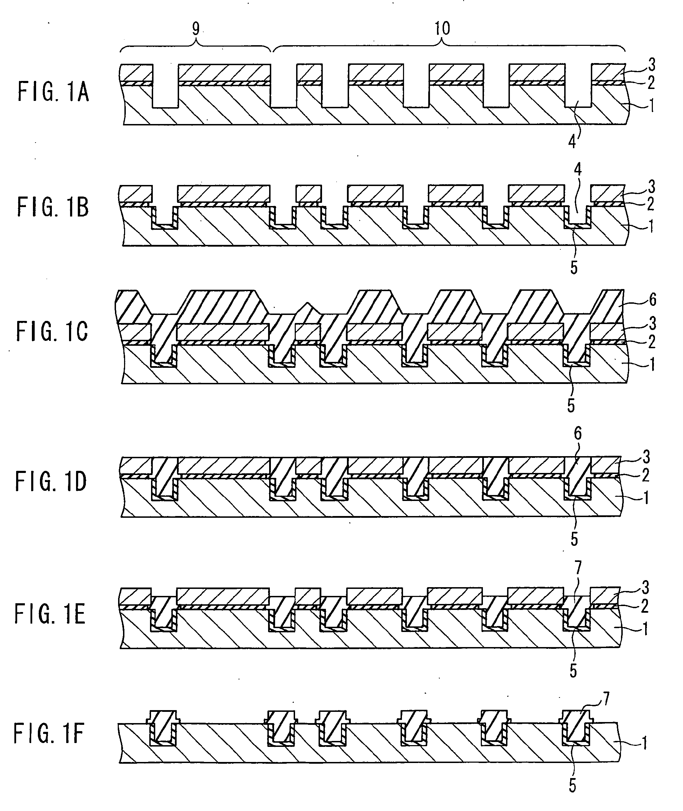

A method for producing a solid-state imaging device in the embodiment of the present invention is preferred in the case of producing a gate oxide film with a thickness equal to or smaller than 10 nm using an STI for element isolation by a fine CMOS logic technology of 0.25 µm or finer. The present embodiment is characterized in that, in a process of forming the STIs, wet etching is carried out using a silicon nitride film as a hard mask after a CMP process. The method for producing a solid-state imaging device in the present embodiment will be described with reference to FIGs. 1A to 1F, which are sectional views showing the production process. Numeral 9 denotes a peripheral circuit region, and numeral 10 denotes a pixel region.

First, as shown in FIG. 1A, a protective oxide film 2 and a silicon nitride film 3 are formed on a silicon substrate 1 by a known technique. Next, in the silicon nitride film 3 and the protective oxide film 2 in a region where STIs are to be formed, through holes are formed by photolithography and dry etching, thus forming silicon trenches 4 (groove portions) in the silicon substrate 1.

Subsequently, as shown in FIG. 1B, the protective oxide film 2 is etched from lateral surfaces of the silicon trenches 4 by wet etching (for example, for 100 seconds using a solution ofBHF : H₂O = 20 : 1) so as to oxidize lateral walls of the silicon trenches 4, thus forming a thermal oxide film 5 having a thickness of 15 nm on the lateral surfaces of the silicon trenches 4 and a thickness of 30 nm on bottom portions thereof. Next, boron is implanted into the lateral walls of the silicon trenches 4 by photolithography and ion implantation. For example, four steps of the implantation are carried out at an implantation energy of 30 keV and a dose of 8 × 10¹² cm⁻².

By the oxidation of the lateral walls and the implantation in the lateral walls of the silicon trenches 4, dangling bonds of silicon atoms, etc. in surfaces of the silicon trenches 4 are made electrically inactive. This reduces the influence that a depletion layer generated owing to a photodiode diffusion layer, which will be formed near the STI lateral walls in a later process, has on the silicon atoms in the surfaces of the silicon trenches 4, making it possible to prevent a leakage electric current from a photodiode.

Then, as shown in FIG. 1C, an NSG film (buried oxide film) 6 forming the STIs is deposited by HDP (High Density Plasma) CVD on the silicon nitride film 3 so as to fill the silicon trenches 4. Here, in order to alleviate the influence of plasma damages due to the HDP CVD, it is desired that TEOS (tetraethoxysilane) be grown (so as to have a thickness of 20 nm, for example) further on the lateral walls of the silicon trenches 4 by thermal CVD without using plasma before depositing the NSG film 6. Moreover, it is desired that annealing be carried out (for example, at 900°C for 30 minutes in a nitrogen atmosphere) after depositing the NSG film 6, thereby improving the quality of the NSG film 6.

Next, as shown in FIG. 1D, the NSG film 6 on the silicon nitride film 3 is flattened by CMP (Chemical Mechanical Polish). At the time of flattening by the CMP process, it is desired not to etch the buried oxide film (the NSG film 6) in the active region in the pixel region 10 using a reverse mask, unlike the general CMOS logic process. This is because the active region in the pixel region 10 is too small to be etched appropriately using the reverse mask as described above.

By the CMP process, the NSG film 6 is flattened so as to have a substantially equal height as the silicon nitride film 3. Incidentally, it is preferable that the thickness of the silicon nitride film 3 ground by the CMP is set to be equal to or smaller than 50% of the initially formed thickness. By setting the thickness ground by the CMP to be equal to or smaller than 50% as mentioned above, it is possible to suppress the variation in step height of the flattened NSG film 6.

Then, as shown in FIG. 1E, the flattened NSG film 6 is etched vertically by another wet etching (for example, BHF : H₂O = 20 : 1) using the silicon nitride film 3 as a hard mask. In other words, although the thickness of the NSG film 6 conventionally has been adjusted by the CMP alone, the wet etching process is added in the present invention, thereby making it possible to control the thickness of STIs 7 by the amount of CMP and wet etching. The NSG film 6 is ground by the CMP and wet etching so as to be formed into the STIs 7. Incidentally, it is preferable that the thickness of the NSG film 6 etched by the wet etching is set to be 10% to 50% of the initially formed silicon nitride film 3 (before the CMP).

Next, as shown in FIG. 1F, after the wet etching, the silicon nitride film 3 is removed by a hot phosphoric acid etching, and the protective oxide film 2 before forming a gate oxide film is removed by wet etching (for example, for 20 seconds using a solution of BHF : H₂O = 20 : 1). Subsequently, a gate insulating film (not shown) and polysilicon, which is a gate material, are formed in the active region in the pixel region 10, thereby forming a gate electrode. An STI step height is determined by the height of an upper end of the polysilicon at the time of forming the polysilicon. Incidentally, it is preferable that the STI step height is equal to or smaller than 40 nm.

Thereafter, a photodiode for converting incident light into an electrical charge and storing it, and a MOS transistor of a readout portion for reading out a signal charge from the photodiode, a driving portion or an amplification portion for amplifying an output signal are formed in the pixel region 10 and the peripheral circuit region 9.

As described above, by wet-etching the buried NSG film 6 while leaving the silicon nitride film 3, it is possible to form uniform STI step heights.

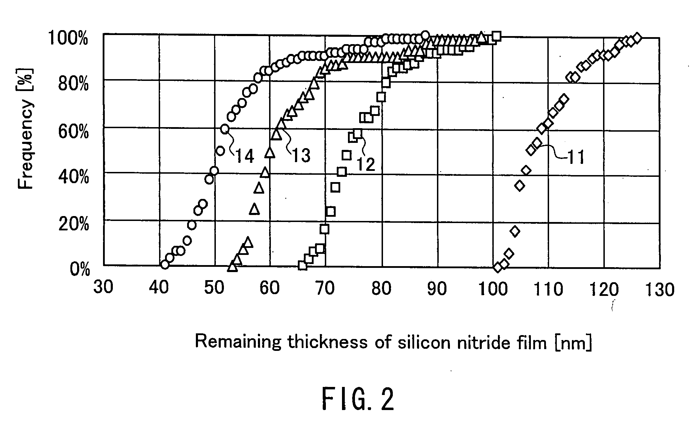

FIG. 2 is a graph showing a cumulative frequency distribution of the remaining thickness of the silicon nitride film 3 after the CMP shown in FIG. 1D. FIG. 2 shows the cases 11, 12, 13 and 14 where the average remaining thickness is 105 nm, 75 nm, 65 nm and 50 nm, respectively. As shown in FIG. 2, the thickness at frequencies between 0% and 100% with respect to each of the average remaining thicknesses indicates a thickness variation of the silicon nitride film 3 after the CMP. According to this graph, for example, the variation range is about 25 nm when the average remaining thickness is 105 nm, and the variation range is about 47 nm when the average remaining thickness is 50 nm.

With a decrease in the remaining thickness of the silicon nitride film 3, in other words, with an increase in the polished amount of the silicon nitride film 3, the variation in the remaining thickness of the silicon nitride film 3 in a wafer surface increases. The amount of the silicon nitride film 3 polished by the CMP and the variation in the remaining thickness of the silicon nitride film 3 in the wafer surface substantially are in a proportional relationship.

Thus, it is preferable that the amount of the silicon nitride film 3 polished by the CMP is minimized to the extent that the NSG film 6 on the active region can be removed, in other words, the silicon nitride film 3 is not polished excessively while the NSG film 6 on the silicon nitride film 3 is removed completely. Further, it is preferable that a predetermined amount of the NSG film 6 is wet-etched using the silicon nitride film 3 as a hard mask.

By grinding the NSG film 6 in this manner, it is possible to reduce the STI step height while reducing the variation in the STI step heights in the wafer surface. Also, the STI step height is reduced in this way, thereby preventing the generation of a PS residue in the lateral walls of the STI as shown in FIG. 6.

In the conventional method, when the height of the STI buried oxide film on the peripheral circuit is optimized, the STI step height in the pixel region 10 has been larger. In contrast, according to the present production method, even when the height in the pixel cell is optimized, the STI step height in the peripheral circuit region 9 is not reduced excessively. Also, even when the STI step height is small, corner portions of the active region of the semiconductor substrate adjacent to the STIs 7 are not exposed, so that the reliability in the corner portions is not reduced due to thinning of the gate oxide film. Therefore, the STI step heights in the pixel region 10 can be reduced. By achieving uniform and reduced STI step heights, it is possible to alleviate the stress caused by the STIs 7 and suppress the generation of crystal defects.

Moreover, it is possible to suppress bridging of the adjacent gates caused by the PS residue on the lateral walls of the STIs. Consequently, defects in an imaging property such as white marks or roughness in a dark image can be solved in a MOS-type solid-state imaging device produced using a fine CMOS logic technology of 0.25 µm or finer.

## Claims

1. A method for forming STIs (Shallow Trench Isolations) in a semiconductor substrate, comprising:
forming a protective oxide film on the semiconductor substrate and forming a silicon nitride film on the protective oxide film;
performing a photolithography and a dry etching so as to penetrate the silicon nitride film and the protective oxide film and remove part of the semiconductor substrate, thus forming groove portions;
forming a buried oxide film in the groove portions and on the silicon nitride film;
removing the buried oxide film on the silicon nitride film and a surface portion of the silicon nitride film by a CMP (Chemical Mechanical Polish); and
removing part of the buried oxide film deposited in the groove portions by a wet etching.

2. The method for forming STIs according to claim 1, wherein a thickness of the surface portion of the silicon nitride film removed by the CMP is equal to or smaller than 50% of a thickness of the silicon nitride film that is formed, and
a thickness of the buried oxide film removed by the wet etching is 10% to 50% of a thickness of the silicon nitride film before the CMP.

3. A method for producing a semiconductor device comprising:
forming a semiconductor element between the STIs formed by the method according to claim 1.

4. A method for producing a semiconductor device comprising:
forming a semiconductor element between the STIs formed by the method according to claim 2.

5. The method for producing a semiconductor device according to claim 3 wherein the semiconductor element is formed so as to form a photodiode for converting incident light into an electrical charge and storing it, and a MOS transistor forming a readout portion for reading out a signal charge from the photodiode, a driving portion or an amplification portion for amplifying an output signal.

6. The method for producing a semiconductor device according to claim 4 wherein the semiconductor element is formed so as to form a photodiode for converting incident light into an electrical charge and storing it, and a MOS transistor forming a readout portion for reading out a signal charge from the photodiode, a driving portion or an amplification portion for amplifying an output signal.

7. A semiconductor device produced by the method according to claim 3,
wherein a height of an upper end of the STIs is equal to or smaller than 40 nm from the semiconductor substrate.

8. A semiconductor device produced by the method according to claim 4,
wherein a height of an upper end of the STIs is equal to or smaller than 40 nm from the semiconductor substrate.

9. A semiconductor device produced by the method according to claim 5,
wherein a height of an upper end of the STIs is equal to or smaller than 40 nm from the semiconductor substrate.

10. A semiconductor device produced by the method according to claim 6,
wherein a height of an upper end of the STIs is equal to or smaller than 40 nm from the semiconductor substrate.
